Europäisches Patentamt

European Patent Office

Office européen des brevets

(19)

(11) EP 1 605 273 A1

(12) DEMANDE DE BREVET EUROPEEN

(43) Date de publication:
14.12.2005 Bulletin 2005/50

(51) Int Cl.⁷: G01R 31/36

(21) Numéro de dépôt: 05291189.8

(22) Date de dépôt: 02.06.2005

(84) Etats contractants désignés:
AT BE BG CH CY CZ DE DK EE ES FI FR GB GR
HU IE IS IT LI LT LU MC NL PL PT RO SE SI SK TR
Etats d'extension désignés:
AL BA HR LV MK YU

(30) Priorité: 09.06.2004 FR 0406241

(71) Demandeur: Peugeot Citroen Automobiles S.A.
78140 Vélizy Villacoublay (FR)

(72) Inventeurs:
• Porcellato, Denis
  92420 Vaucresson (FR)
• Maugy, Christian
  80500 Remaugies (FR)

(74) Mandataire: Domenego, Bertrand et al
Cabinet Lavoix
2, place d'Estienne d'Orves
75441 Paris Cedex 09 (FR)

(54) **Dispositif et procédé d'estimation de pertes par effet joule et d'état de charge d'une batterie**

(57)     Ce dispositif d'estimation des pertes par effet joule comporte :

-    un module (42) de calcul des tensions ou courants entre les bornes de chaque résistance d'un modèle électrique prédéfini de la batterie en fonction de l'intensité et de la tension mesurées entre les bornes de la batterie, ce modèle électrique prédéfini comportant une première résistance raccordée en série avec un premier circuit RC (Résistance - Condensateur) parallèle et au moins un second circuit RC parallèle, et
-    un module (84) d'évaluation des pertes par effet joule en fonction de la valeur des résistances du modèle électrique prédéfini et des tensions ou courants calculés entre les bornes de ces résistances.

FIG.1

**Description**

L'invention concerne la détermination de l'état de charge et des pertes par effet joule d'une batterie.

Des dispositifs connus d'estimation des pertes par effet joule d'une batterie comportent :

- un capteur de l'intensité du courant circulant entre les bornes de la batterie,
- un capteur de la tension entre les bornes de la batterie.

Dans ces dispositifs connus, à partir des informations mesurées par ces capteurs, les pertes par effet joule sont calculées à l'aide d'une formule empirique déterminée le plus souvent de façon expérimentale. Pour tenir compte de la complexité des phénomènes électrochimiques qui se produisent dans la batterie, ces formules empiriques sont généralement compliquées. Par conséquent, les dispositifs d'estimation connus qui mettent en œuvre ces formules sont eux-mêmes compliqués.

L'invention vise à remédier à cet inconvénient en proposant un dispositif d'estimation des pertes par effet joule d'une batterie plus simple.

L'invention a donc pour objet un dispositif d'estimation des pertes par effet joule d'une batterie comportant :

- un module de calcul des tensions ou courants entre les bornes de chaque résistance d'un modèle électrique prédéfini de la batterie en fonction de l'intensité et de la tension mesurées par les capteurs, ce modèle électrique prédéfini comportant une première résistance, un premier circuit RC (Résistance
- Condensateur) parallèle et au moins un second circuit RC parallèle raccordés successivement en série, et
- un module d'évaluation des pertes par effet joule en fonction de la valeur des résistances du modèle électrique prédéfini et des tensions ou courants calculés entre les bornes de ces résistances.

Grâce à la simplicité du modèle électrique de la batterie utilisé dans le dispositif d'estimation ci-dessus, ce dispositif d'estimation est simple à réaliser.

Suivant d'autres caractéristiques prises seules ou en combinaison du dispositif d'estimation des pertes par effet joule d'une batterie, celui-ci se caractérise en ce que :

- la valeur de la première résistance est fonction de la résistance de l'électrolyte et des matériaux formant les électrodes de la batterie,
- la valeur de la résistance du premier circuit RC est fonction de la résistance de transfert de charge entre l'électrolyte et les électrodes de la batterie,
- la valeur de la résistance du ou de chaque second circuit RC est fonction du phénomène de diffusion des éléments chargés dans l'électrolyte de la batterie.
- la valeur du condensateur du premier circuit RC est fonction du phénomène de double couche apparaissant à l'interface entre l'électrolyte et les électrodes,
- la valeur du condensateur du ou de chaque second circuit RC est fonction du phénomène de diffusion des éléments chargés dans l'électrolyte de la batterie.
- le module de calcul est propre à calculer la tension aux bornes du premier circuit RC et la tension aux bornes du ou de chaque second circuit RC ;
- le module d'évaluation est apte à calculer les pertes par effet joule à l'aide de la formule suivante :

$$Pj = Rohm\, i^2 + Vtc^2 / Rtc + \sum_{j=1}^{n} Vj^2 / Rj$$

où :

- Rohm est la valeur de la première résistance,
- i est l'intensité du courant mesuré par le capteur d'intensité,
- Vtc est la tension aux bornes du premier circuit RC,
- Rtc est la valeur de la résistance du premier circuit RC,
- Vj est la tension aux bornes du j-ième second circuit RC,
- Rj est la résistance du j-ième second circuit RC,
- n est un entier supérieur ou égal à 1, et
- Pj est l'estimation des pertes par effet joule de la batterie.

- il comporte un capteur de température de la batterie et un module de détermination de la valeur des résistances du modèle en fonction de la température mesurée par ce capteur ;
- il comporte un module de détermination de la valeur des résistances du modèle en fonction de l'état de charge actuel de la batterie.

L'invention concerne également un système d'estimation de l'état de charge actuel d'une batterie en fonction des puissances électriques reçue et dissipée par la batterie, caractérisé en ce que ce système comporte un dispositif d'estimation des pertes par effet joule conforme à l'une quelconque des revendications précédentes pour estimer la puissance électrique dissipée par la batterie.

Suivant une autre caractéristique du système ci-dessus, celui-ci comporte un estimateur propre à estimer la puissance électrique reçue par la batterie en fonction de l'intensité circulant dans la batterie et de la tension aux bornes de cette batterie.

L'invention concerne également un procédé d'estimation des pertes par effet joule d'une batterie comportant les étapes consistant à :

- mesurer l'intensité du courant traversant la batterie,
- mesurer la tension aux bornes de la batterie,

caractérisé en ce que ce procédé comporte également les étapes consistant à :

- calculer la tension ou le courant entre les bornes de chaque résistance d'un modèle électrique prédéfini de la batterie en fonction de l'intensité et de la tension mesurées, ce modèle électrique prédéfini comportant une première résistance, un premier circuit RC (Résistance - Condensateur) parallèle et au moins un second circuit RC parallèle raccordée successivement en série, et
- évaluer les pertes par effet joule en fonction de la valeur des résistances du modèle électrique prédéfini et des tensions ou courants calculés entre les bornes de ces résistances.

L'invention concerne également un procédé d'estimation de l'état de charge d'une batterie comportant une étape d'estimation des pertes par effet joule réalisée conformément au procédé d'estimation des pertes par effet de joule conforme à l'invention, pour estimer la puissance électrique dissipée par la batterie.

L'invention sera mieux comprise à la lecture de la description qui va suivre donnée uniquement à titre d'exemple et faite en se référant aux dessins sur lesquels :

- la figure 1 est une vue schématique de la structure d'un véhicule comportant un système d'estimation de l'état de charge d'une batterie ;
- la figure 2 est un schéma électrique d'un modèle électrique de la batterie du véhicule de la figure 1 ;
- la figure 3 est une vue schématique d'un banc d'essai pour déterminer les valeurs des différents composants du modèle électrique de la figure 2 ;
- la figure 4 est un procédé de détermination des valeurs des composants du modèle électrique de la figure 2 ;
- la figure 5 est un diagramme de Nyquist de l'impédance de la batterie du véhicule de la figure 1 ; et
- la figure 6 est un organigramme d'un procédé d'estimation de l'état de charge d'une batterie.

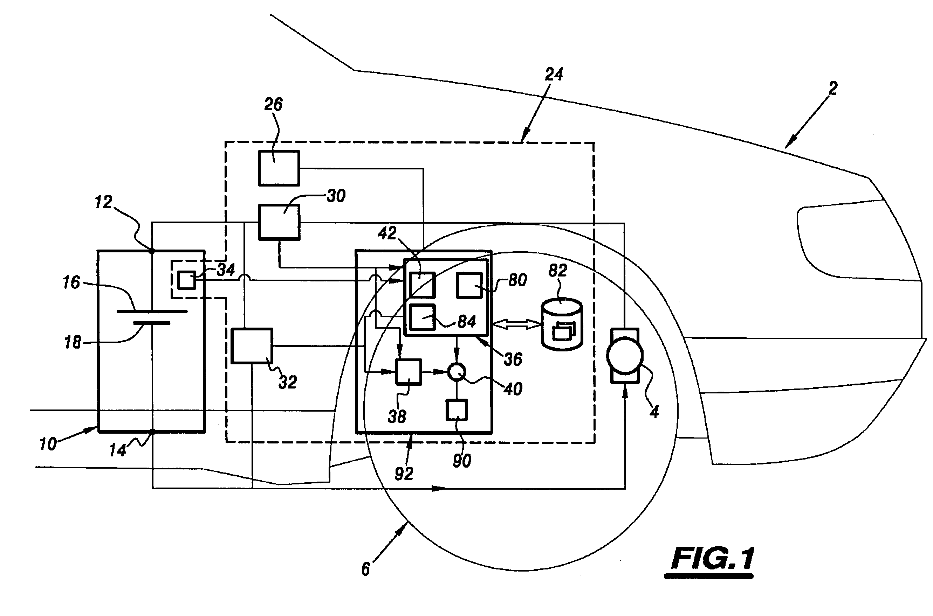

La figure 1 représente un véhicule automobile électrique ou hybride 2 équipé d'un moteur électrique 4 propre à entraîner en rotation des roues motrices 6 du véhicule. Le véhicule 2 comporte également une batterie électrique 10 comportant deux bornes de raccordement 12 et 14 connectées au moteur 4 pour l'alimenter en courant continu.

Pour simplifier l'illustration, cette batterie 10 comporte uniquement deux électrodes, c'est-à-dire ici une anode 16 et une cathode 18 entre lesquelles se trouve un électrolyte 20. La batterie 10 est par exemple une batterie NiMH (Nickel Métal Hydrure).

Le véhicule 2 comporte également un système 24 d'estimation de l'état de charge de la batterie 10.

Le système 24 comporte, par exemple, un écran 26 d'affichage de l'état de charge actuel de la batterie 10 placé dans l'habitacle du véhicule 2 de manière à ce que celui-ci puisse être consulté par le conducteur.

Le système 24 possède des moyens d'acquisition d'informations sur le fonctionnement de la batterie. Ces moyens d'acquisition comportent :

- un capteur 30 de l'intensité du courant reçu par la batterie 10,
- un capteur 32 de la tension entre les bornes 12 et 14, et
- un capteur de température 34 propre à mesurer la température de la batterie 10.

A titre d'exemple, le capteur 34 est logé à l'intérieur de la batterie 10.

Pour calculer l'état de charge de la batterie 10 à partir des informations mesurées par les capteurs 30, 32 et 34, le système 24 comporte deux estimateurs 36 et 38 pour estimer respectivement la puissance électrique dissipée par la batterie 10 et la puissance électrique reçue par cette même batterie.

L'estimateur 36 comporte trois entrées raccordées respectivement aux capteurs 30, 32 et 34 pour recevoir les informations mesurées par ces capteurs. L'estimateur 36 comporte également une sortie raccordée à une borne d'entrée négative d'un soustracteur 40.

Dans ce mode de réalisation, la puissance électrique dissipée est supposée égale aux pertes par effet joule de la batterie 10.

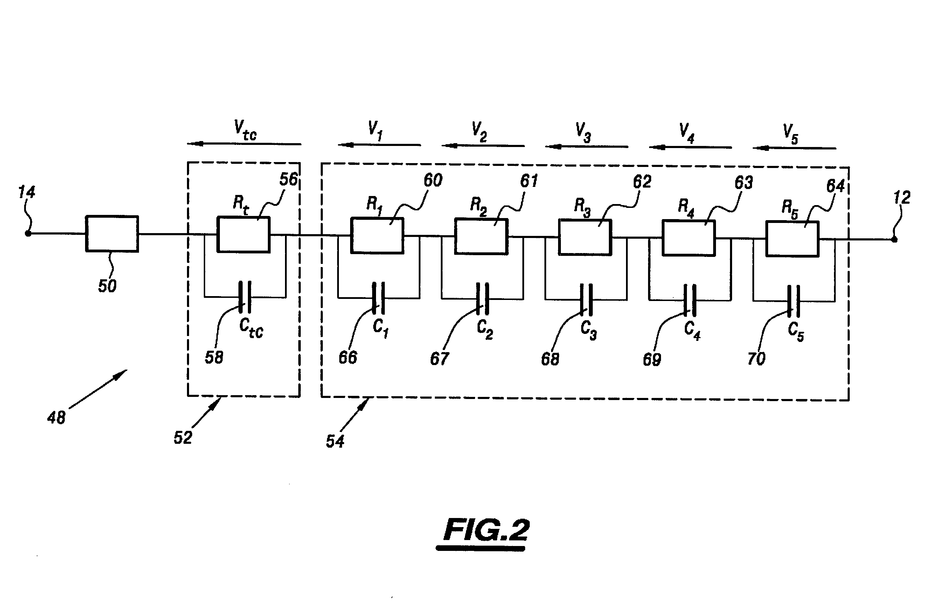

Pour calculer les pertes par effet joule, l'estimateur 36 comporte un module 42 de calcul des tensions et/ou des courants entre les bornes de chaque résistance d'un modèle électrique prédéfini 48 (figure 2) de la batterie 10.

Sur cette figure 2, les bornes de raccordement de la batterie 10 portent les mêmes références. Le modèle 48 comporte une résistance 50, un circuit RC (Résistance - Condensateur) parallèle 52 et une impédance 54 raccordés successivement en séries entre les bornes 12 et 14.

La résistance 50 modélise la résistance de l'électrolyte 20 et des matériaux formant l'anode 16 et la cathode 18. Le courant traversant cette résistance 50 est noté i sur cette figure.

Le circuit RC 52 comporte une résistance 56 et un condensateur 58 raccordés en parallèle. La résistance 56 est appelée résistance de transfert de charge et représente la facilité avec laquelle se produit le transfert d'électrons entre les électrodes de la batterie 10 et les cations présents dans l'électrolyte. Le transfert d'électrons entre une électrode et l'électrolyte correspond à la réaction électrochimique réversible $A^{+}+e^{-} \rightarrow A$ qui se produit à l'interface entre l'électrode et l'électrolyte.

Le condensateur 58 représente la capacité créée par le phénomène de double couche électrique qui est associé au phénomène de transfert d'électrons entre une électrode et l'électrolyte. Plus précisément, le phénomène de double couche électrique correspond à l'accumulation de charges de part et d'autre de l'interface entre une électrode et l'électrolyte. Ce phénomène est d'autant plus important que le transfert d'électrons est lent. Il y a donc accumulation de charges, par exemple positives, du côté de l'électrolyte et accumulation de charges, par exemple négatives, du côté de l'électrode. C'est ce phénomène que modélise le condensateur 58.

L'impédance 54 modélise le phénomène de diffusion d'espèces chargées sous l'influence d'un gradient de potentiel chimique. Ce phénomène de diffusion correspondant à un flux de matières est calculé, par exemple, à partir des première et seconde lois de FICK. Ici, pour modéliser les conséquences électriques de ce phénomène de diffusion, l'impédance 54 se compose de $n$ circuits RC parallèles raccordés en série. $n$ est un entier supérieur ou égal à 1. Plus l'entier $n$ est grand, meilleure est la précision du modèle 48. Ici, pour ne pas obtenir un modèle électrique trop compliqué tout en conservant une bonne précision, $n$ est compris entre 3 et 15. Ici, sur la figure 2, $n$ est égal à 5.

Chaque circuit RC de l'impédance 54 comporte une résistance en parallèle avec un condensateur. Les résistances du premier au cinquième circuits RC sont désignées respectivement par les références 60 à 64. Les condensateurs du premier au cinquième circuits RC sont désignés respectivement par les références 66 à 70.

On notera que pour établir le modèle électrique de la batterie 10, les phénomènes de migration, également connus sous le terme d'électromigration, correspondant au mouvement d'une ou plusieurs espèces chargées sous l'influence d'un champs électrique ont été négligés. De façon similaire, les phénomènes de convexion correspondant à une agitation ou à un transport hydrodynamique de matières chargées dans l'électrolyte ont été négligés. Typiquement, ces phénomènes de convexion sont soit naturels tels que par exemple ceux provoqués par un gradient de température, soit forcés, c'est-à-dire engendrés, par exemple, par un agitateur mécanique.

Dans la suite de cette description, la tension aux bornes du circuit RC 52 est notée Vtc et les tensions aux bornes des premier au cinquième circuits RC de l'impédance 54 sont notées respectivement V1, V2, V3, V4 et V5.

Ainsi en utilisant les notations introduites ci-dessus, le module 42 est ici plus précisément adapté pour calculer la tension Vtc et les tensions V1 à V5 à partir de l'intensité mesurée par le capteur 30 et de la tension U mesurée par le capteur 32. Ce calcul est réalisé à l'aide des lois classiques de l'électricité et ne sera donc pas décrit ici en détail. L'intensité i étant directement mesurée par le capteur 30, celle-ci n'a pas besoin d'être calculée.

Pour calculer les différentes tensions du modèle 48, le module 42 a besoin de connaître la valeur des différents composants électriques de ce modèle, c'est-à-dire la valeur des résistances 50, 56, 60 à 64 et des condensateurs 58 et 60 à 70. A cet effet, l'estimateur 36 comporte un module 80 de détermination des valeurs des composants électriques du modèle 48. Plus précisément, pour obtenir une plus grande précision dans l'estimation des pertes par effet joule de la batterie 10, les valeurs des composants électriques du modèle 48 sont ici fonction à la fois de la température de la batterie 10 et de son état de charge actuel. Dès lors, le module 80 est plus spécialement adapté pour déterminer la valeur de ces composants en fonction de la température mesurée par le capteur 34 et de l'état de charge précédemment estimé par le système 24.

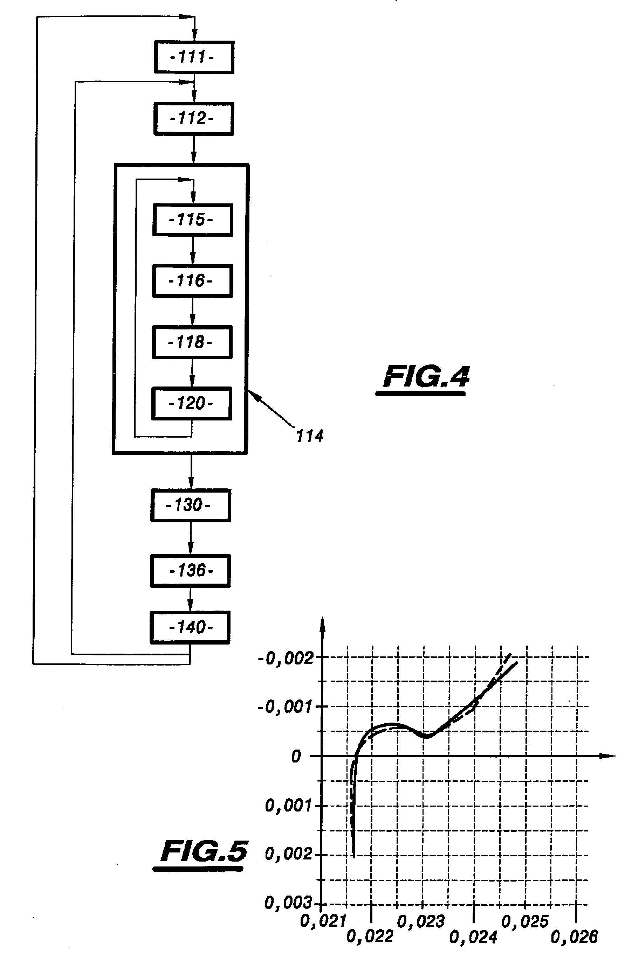

Ici, pour réaliser cette tâche, le module 80 est associé à une mémoire 82 dans laquelle sont enregistrées les valeurs des composants électriques du modèle 48 pour différentes plages de températures et d'états de charge de la batterie 10. La structure des données enregistrées dans la mémoire 82 sera décrite plus en détail ci-dessous en regard du procédé de la figure 4.

Finalement, l'estimateur 36 comporte un module 84 d'évaluation des pertes par effet joule en fonction de la valeur des résistances du modèle 48, et des tensions calculées par le module 42 et de l'intensité i mesurée. Ce module 84 évalue les pertes par effet joule de la batterie 10 en calculant l'énergie dissipée par les résistances du modèle 48. A cet effet, le module 84 utilise, par exemple, la formule suivante :

$$Pj = Rohm\, i^2 + Vtc^2 / Rtc + \sum_{j=1}^{5} Vj^2 / Rj$$

où :

- Pj est la puissance électrique dissipée par effet joule,
- Rohm est la valeur de la résistance 50,
- i est l'intensité du courant mesuré par le capteur 30,
- Vtc est la tension aux bornes du circuit RC 52,
- Rtc est la valeur de la résistance 56,
- Vj est la tension aux bornes du j-ième circuit RC de l'impédance 54, et
- Rj est la valeur de la résistance du j-ième circuit RC de l'impédance 54.

L'estimateur 38 comporte deux entrées respectivement raccordées aux capteurs 30 et 32 et une sortie raccordée à la borne positive du soustracteur 40. Pour calculer la puissance électrique reçue par la batterie 10, l'estimateur 38 utilise par exemple la formule suivante :

$$Pe = U.i$$

ou :

- $P_e$ est la puissance électrique reçue par la batterie 10,
- U est la tension mesurée par le capteur 32, et
- i est l'intensité du courant mesurée par le capteur 30.

Le soustracteur 40 comporte une sortie raccordée à l'entrée d'un intégrateur 90 pour délivrer en continu à cet intégrateur la différence entre les puissances $P_j$ et $P_e$ estimées respectivement par les estimateurs 36 et 38.

L'intégrateur 90 est propre à réaliser l'opération mathématique suivante :

$$SOC(t) = \left( SOCo - \int_{to}^{t} \frac{(Pe - Pj)}{E_{nom}} dt \right) x100$$

où:

- SOC(t) est l'estimation de l'état de charge de la batterie 10 à l'instant actuel t, exprimée en pourcentage (100% correspondant à une batterie pleinement chargée et 0% correspondant à une batterie complètement déchargée),
- $SOC_0$ est l'état de charge initial de la batterie à l'instant $t_o$,
- $E_{nom}$ est une constante dont la valeur est égale à l'énergie nominale de la batterie 10 lorsque celle-ci est pleinement chargée.

L'instant $t_o$ correspond à l'instant auquel l'intégrateur 90 commence à calculer l'estimation de l'état de charge de la batterie 10.

La constante $E_{nom}$ est une constante prédéterminée enregistrée, par exemple, dans la mémoire 82.

L'intégrateur 90 est apte à transmettre au dispositif d'affichage 26 la valeur calculée de SOC(t) pour affichage de celle-ci.

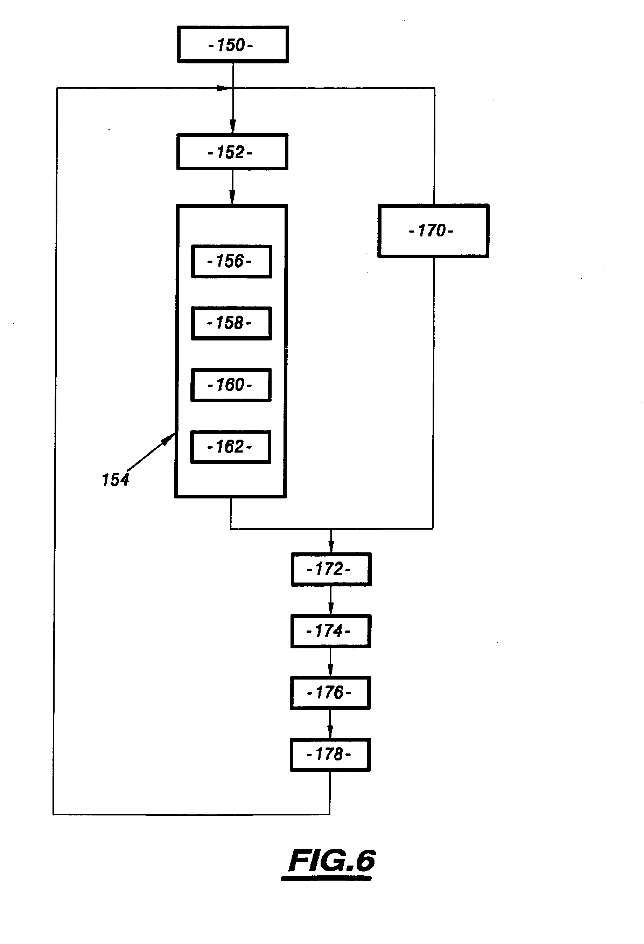

Ici, les estimateurs 36 et 38, le soustracteur 40 et l'intégrateur 90 sont implémentés dans un calculateur électronique programmable conventionnel 92 associé à la mémoire 82. A cet effet, la mémoire 82 comporte des instructions pour l'exécution du procédé de la figure 6 lorsque ces instructions sont exécutées par le calculateur 92.

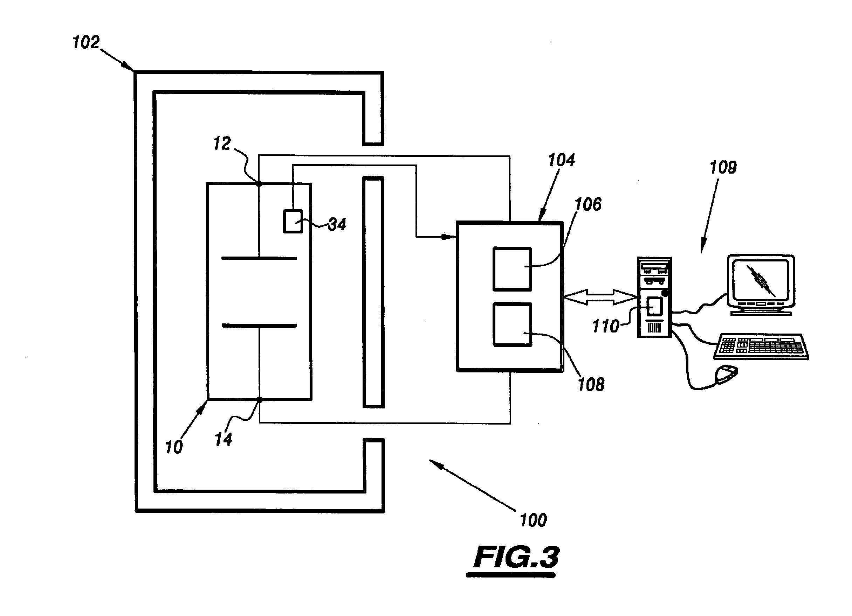

La figure 3 représente un banc, désigné par la référence générale 100, de détermination des valeurs des composants électriques du modèle 48.

Le banc 100 comporte une enceinte thermique 102 à l'intérieur de laquelle est logée la batterie 10. Cette enceinte permet de maintenir la température du milieu ambiant dans lequel est logée la batterie 10 à une température constante fixée.

Le banc 100 comporte également un appareil de mesure 104 raccordé aux bornes 12 et 14 de la batterie 10 ainsi qu'au capteur 34 de température.

Cet appareil 104 est apte à placer la batterie 10 dans un état de charge connu. De plus, il comporte un générateur 106 de tension alternative propre à appliquer entre les bornes 12 et 14 une tension alternative de pulsation w connue. On rappelle que la pulsation est la fréquence de la tension exprimée en radians.

Enfin, l'appareil 104 comporte un dispositif 108 de relevé du signal électrique généré par la batterie 10 en réponse à l'application d'une tension alternative.

L'appareil 104 est associé à un ordinateur 109 équipé d'un logiciel 110. Ce logiciel 110 est apte à construire le diagramme de Nyquist de l'impédance de la batterie 10 en fonction des tensions générées par le générateur 106 et des réponses relevées par le dispositif 108. Ce logiciel est également apte à calculer la valeur des différents composants électriques du modèle 48 à partir de l'impédance de la batterie mesurée à différentes fréquences.

Le fonctionnement du banc 100 va maintenant être décrit en regard du procédé de la figure 4 puis le fonctionnement du système 24 sera décrit en regard de la figure 6.

La figure 4 représente un procédé de détermination de la valeur des composants électriques du modèle 48 en fonction de l'état de charge de la batterie 10 et de la température mesurée par le capteur 34.

Initialement l'enceinte thermique 102 est pilotée, lors d'une étape 111, pour amener le milieu ambiant dans lequel est logée la batterie 10 à une température constante connue.

Ensuite, lors d'une étape 112, l'appareil 104 amène la batterie dans un état de charge connu.

Dans ces conditions, l'impédance complexe de la batterie 10 est mesurée lors d'une étape 114.

Plus précisément, une opération 115 d'attente est initialisée. Lors de cette opération 115 aucune tension alternative n'est appliquée aux bornes de la batterie 10. L'opération d'attente 115 se prolonge tant que l'amplitude des oscillations de la tension entre les bornes 12 et 14 de la batterie 10 n'est pas inférieure à 5 mV et de préférence inférieure à 3 mV. Cette étape 115 permet d'attendre que la batterie 10 revienne dans un état proche de l'état d'équilibre c'est-à-dire dans un état où la tension aux bornes de la batterie 10 est pratiquement constante. De cette manière, on évite qu'une mesure d'impédance qui vient d'être réalisée, ne perturbe les prochaines mesures d'impédance. En d'autres termes, comme il apparaîtra à la lecture de la description qui suit, les mesures réalisées pour différentes valeurs de la pulsation $\omega$ sont décorrélées les unes des autres grâce à cette opération 115.

Ensuite, lors d'une opération 116, une tension alternative $U'=U_0 \cos(\omega t)$ est appliquée entre les bornes 12 et 14 de la batterie 10 par le générateur 106. La réponse à ce signal de tension U' est relevée, lors d'une opération 118, par le dispositif 108. Plus précisément, le dispositif 108 relève l'intensité i' qui traverse la batterie 10. L'intensité relevée peut s'écrire sous la forme suivante :

$$I'=i_0\cos(\omega t+\phi)$$

où :

- $i_0$ est la valeur efficace du courant,
- w est la pulsation,
- $\phi$ est le déphasage par rapport à la tension imposée U'.

Une fois l'intensité relevée, le générateur de tension 106 est arrêté, lors d'une opération 120.

Après, les opérations 115 à 120 sont réitérées avec une tension alternative de pulsation connue différente.

Ces opérations 115 à 120 sont réitérées un nombre de fois supérieur ou égale au nombre de composants électriques du modèle 48, c'est-à-dire ici au moins treize fois, avec à chaque fois une pulsation différente. Dans ce mode de réalisation, pour obtenir une meilleure précision, le nombre de fois où les opérations 115 à 120 sont réitérées pour différentes pulsations est strictement supérieur au nombre de composants électriques du modèle 48 et de préférence deux, trois ou quatre fois supérieurs à ce nombre de composants électriques.

Ces opérations 115 à 120 sont réitérées pour un grand nombre de pulsations comprises entre 0,001 $H_z$/rd et 1000 $H_z$/rd. La plage de valeurs de pulsations est choisie en fonction de la batterie testée. Toutefois, généralement, des valeurs de pulsations supérieurs à 1000 $H_z$/rd ne sont pas utiles.

Une fois que l'impédance complexe de la batterie 10 a été mesurée pour un grand nombre de pulsations, le diagramme de Nyquist de l'impédance complexe de la batterie 10 est construit lors d'une étape 130 par le logiciel 110. Pour ce faire, pour chaque pulsation utilisée lors de l'étape 114, la partie réelle $Z_r(\omega)$ est la partie imaginaire $Z_i(\omega)$ de l'impédance complexe de la batterie 10 est calculée à partir des mesures réalisées lors de l'étape 114 en utilisant, par exemple, les formules suivantes :

$$Z_r(\omega)=(U_0/i_0)\cos\phi$$

$$Z_i(\omega)=(U_0/i_0)\sin\phi$$

Un exemple de diagramme de Nyquist construit pour la batterie 10 est représenté sur la figure 5. Pour chaque pulsation utilisée lors de l'étape 114, un point ayant comme abscisse la partie réelle $Z_r$ et comme ordonnée la partie imaginaire $Z_i$ est construit. Une courbe 134 en tirets relie l'ensemble de ces points.

Ensuite, le logiciel 110 calcule, lors d'une étape 136, les valeurs des différents composants électriques du modèle 48, à partir de l'ensemble des mesures d'impédances réalisées lors de l'étape 114. Par exemple, le logiciel 110 fait varier la valeur de chacun des composants électriques du modèle 48 jusqu'à ce que l'impédance complexe du modèle 48 corresponde à celle mesurée pour la batterie 10. A titre d'illustration seulement, une courbe 138 représente dans le diagramme de Nyquist de la figure 5 l'impédance complexe du modèle 48 avec les valeurs déterminées par le logiciel 110.

On notera qu'il est possible d'obtenir un modèle dont l'impédance complexe se rapproche encore plus de l'impédance complexe mesurée pour la batterie en augmentant le nombre n de circuits RC parallèles de l'impédance 54.

Une fois, que les valeurs du modèle 48 ont été déterminées, celles-ci sont enregistrées, lors d'une étape 140, dans la mémoire 82 associées à la température relevée par le capteur 34 et à l'état de charge fixé lors de l'étape 112.

Ensuite, le procédé retourne à l'étape 112 de manière à réitérer les étapes 114 à 140 avec un état de charge différent. Par exemple, les étapes 114 à 140 seront réitérées pour des états de charge de la batterie 10 formant une progression géométrique de raison au maximum égale à dix entre l'état pleinement chargé et l'état complètement déchargé.

Enfin, l'ensemble des étapes précédentes sont réitérées pour différentes températures fixées par l'enceinte 102. Ainsi, en fin de compte, la mémoire 82 comporte différentes valeurs prédéfinies fonctions de la température et de l'état de charge de la batterie pour chaque composant électrique du modèle 48.

La figure 6 représente un procédé de fonctionnement du système 24.

Initialement, a chaque fois que la batterie est chargée, le nouvel état de charge initial $SOC_0$ de la batterie 10 est mémorisé, lors d'une étape 150, dans la mémoire 82.

Dès que le système 24 est activé, les capteurs 30, 32 et 34 mesurent, lors d'une étape 152, respectivement l'intensité i, la tension U et la température de la batterie 10.

En parallèle, l'estimateur 36 estime, lors d'une étape 154, les pertes par effet joule de la batterie 10 à partir des mesures réalisées lors de l'étape 152. Plus précisément, lors de l'étape 154, le module 80 sélectionne, lors d'une opération 156, dans la mémoire 82, les valeurs des composants électriques du modèle 48 à utiliser en fonction de la température mesurée et du précédent état de charge calculé par le système 24.

Le module 42 utilise les valeurs sélectionnées par le module 80 pour calculer, lors d'une opération 158, la tension Vtc et les tensions V1 à V5.

Une fois ce calcul réalisé, le module 84 évalue les pertes par effet joule lors d'une opération 160 à partir des valeurs des résistances sélectionnées lors de l'étape 156, et des tensions calculées lors de l'opération 158 et de l'intensité mesurée par le capteur 30.

Cette évaluation des pertes par effet joule est délivrée, lors d'une opération 162 au soustracteur 40.

En parallèle à l'étape 154, l'estimateur 38 réalise, lors d'une étape 170, une estimation de la puissance électrique reçue par la batterie 10 et la transmet au soustracteur 40.

Le soustracteur 40 calcule, lors d'une étape 172, la différence entre les puissances Pe et Pj estimées respectivement lors des étapes 170 et 154.

Cette différence est alors transmise à l'intégrateur 90 qui calcule, lors d'une étape 174, une estimation de l'état de charge de la batterie 10 et la délivre au dispositif d'affichage 26.

Le dispositif 26 affiche, lors d'une étape 176 l'estimation de l'état de charge de la batterie 10. Cette estimation est affichée sous la forme d'un pourcentage ou d'un graphique tel qu'un graphique à barre.

L'état de charge actuel de la batterie est également transmis, lors d'une étape 178, au module 80 pour qu'il soit utilisé par ce module pour sélectionner les valeurs des composants électriques du modèle 48 lors de la prochaine itération des étapes 152 à 178.

Enfin, le procédé réitère les étapes précédemment décrites pour mettre à jour en permanence l'état de charge de la batterie 10.

Grâce à la simplicité du modèle 48, l'estimateur 36 exécute rapidement les différents calculs permettant d'estimer les pertes par effet joule de la batterie 10.

De plus grâce à la présence dans le modèle 48 du circuit RC 52 et de l'impédance 54 les estimations sur les pertes par effet joule sont précises puisque les principaux phénomènes électrochimiques qui se produisent dans la batterie 10 sont modélisés.

Ainsi, le modèle 48 est un bon compromis entre d'une part la simplicité du modèle et d'autre part sa précision.

Le fait de choisir différentes valeurs pour les composants électriques du modèle 48 en fonction de la température et de l'état de charge actuel de la batterie permet d'augmenter la précision de l'estimation des pertes par effet joule et donc de l'estimation de l'état de charge actuel.

D'autres modes de réalisation du système 24 sont possibles. En particulier, pour simplifier le système, la valeur des composants électriques du modèle 48 sont, en variante, uniquement fonctions soit de l'état de charge actuel de la batterie, soit de la température mesurée. Dans une autre variante, particulièrement simple, les valeurs des composants électriques du modèle 48 sont des constantes indépendantes à la fois de la température et de l'état de charge courant de la batterie.

Dans un autre mode de réalisation, pour modéliser avec plus de précision le phénomène de diffusion à l'intérieur de la batterie, l'impédance 54 comporte un condensateur raccordé en série avec les circuits RC parallèle.

Ici, l'énergie nominale $E_{nom}$ a été décrite comme étant une constante. En variante, la valeur de $E_{nom}$ est mise à jour en fonction du nombre de cycles de charge/décharge de la batterie déjà réalisé pour tenir compte de l'usure de la batterie.

L'association des capteurs 30, 32 et 34 et de l'estimateur 36 forme un exemple d'un dispositif d'estimation des pertes par effet joule de la batterie 10. Ce dispositif d'estimation peut être utilisé dans d'autres systèmes que le système 24. Par exemple, ce dispositif d'estimation est utilisé dans un système de commande du chargement d'une batterie.

Le système 24 et le procédé de la figure 4 ont été décrits dans le cas particulier d'une batterie NiMH. Toutefois, le système 24 et le procédé de la figure 4 peuvent être appliqués à d'autres batteries telles que, par exemple, des batteries du type plomb/acide, des batteries au lithium ou encore des batteries utilisant les technologies nickel cadmium ou nickel zinc.

Le procédé de la figure 4 est décrit dans le cas particulier où il est utilisé pour déterminer la valeur des composants électriques du modèle 48. Toutefois, ce procédé peut être utilisé pour déterminer la valeur des composants électriques de tout modèle électrique de batterie présentant une impédance complexe ayant des parties réelle et imaginaire non nulles. Par exemple, le procédé de la figure 4 est appliqué à un modèle électrique d'une batterie faisant intervenir des résistances, des condensateurs et éventuellement des impédances raccordées les unes aux autres pour former un modèle différent du modèle 48.

Ce qui a été décrit ci-dessus s'applique à tout type de batterie électrique et pas seulement aux batteries de véhicules automobiles. Par exemple, cela s'applique également à la batterie d'un véhicule automobile à essence.

**Revendications**

**1.** Dispositif d'estimation des pertes par effet joule d'une batterie comportant :

- un capteur (30) de l'intensité du courant circulant entre les bornes de la batterie,
- un capteur (32) de la tension entre les bornes de la batterie,

  **caractérisé en ce qu'**il comporte :

- un module (42) de calcul des tensions ou courants entre les bornes de chaque résistance d'un modèle électrique prédéfini (48) de la batterie en fonction de l'intensité et de la tension mesurées par les capteurs, ce modèle électrique prédéfini comportant une première résistance (50), un premier circuit RC (Résistance - Condensateur) parallèle, et au moins un second circuit RC parallèle raccordés successivement en série, et
- un module (84) d'évaluation des pertes par effet joule en fonction de la valeur des résistances du modèle électrique prédéfini et des tensions ou courants calculés entre les bornes de ces résistances.

**2.** Dispositif selon la revendication 1, pour une batterie comportant des électrodes séparées par un électrolyte, **caractérisé en ce que** :

- la valeur de la première résistance (50) est fonction de la résistance de l'électrolyte et des matériaux formant les électrodes de la batterie,
- la valeur d'une résistance (56) du premier circuit RC est fonction d'une résistance de transfert de charges entre l'électrolyte et les électrodes de la batterie,
- la valeur d'une résistance (60 à 64) du ou de chaque second circuit RC est fonction d'un phénomène de diffusion d'éléments chargés dans l'électrolyte de la batterie.

3. Dispositif selon la revendication 2, **caractérisé en ce que** :

- la valeur d'un condensateur (58) du premier circuit RC est fonction d'un phénomène de double couche apparaissant à l'interface entre l'électrolyte et les électrodes, et
- la valeur d'un condensateur (66 à 70) du ou de chaque second circuit RC est fonction d'un phénomène de diffusion des éléments chargés dans l'électrolyte de la batterie.

4. Dispositif selon l'une quelconque des revendications précédentes, **caractérisé en ce que** le module de calcul (42) est propre à calculer la tension (Vtc) aux bornes du premier circuit RC et la tension (V1 à V5) aux bornes du ou de chaque second circuit RC.

5. Dispositif selon la revendication 4, **caractérisé en ce que** le module d'évaluation (84) est apte à estimer les pertes par effet joule à l'aide de la formule suivante :

$$Pj = Rohm\, i^2 + Vtc^2\,/\,Rtc + \sum\nolimits_{j=1}^{n}\ Vj^2\,/\,Rj$$

où :

- Rohm est la valeur de la première résistance,
- i est l'intensité du courant mesuré par le capteur d'intensité,
- Vtc est la tension aux bornes du premier circuit RC,
- Rtc est la valeur de la résistance du premier circuit RC,
- Vj est la tension aux bornes du j-ième second circuit RC,
- Rj est la résistance du j-ième second circuit RC,
- n est un entier supérieur ou égal à 1, et
- Pj est l'estimation des pertes par effet joule de la batterie.

6. Dispositif selon l'une quelconque des revendications précédentes, **caractérisé en ce qu'**il comporte un capteur (34) de la température de la batterie et un module (80) de détermination de la valeur des résistances du modèle en fonction de la température mesurée par ce capteur.

7. Dispositif selon l'une quelconque des revendications précédentes, **caractérisé en ce qu'**il comporte un module (80) de détermination de la valeur des résistances du modèle en fonction de l'état de charge actuel de la batterie.

8. Système d'estimation de l'état de charge actuel d'une batterie en fonction des puissances électriques reçue et dissipée par la batterie, **caractérisé en ce que** ce système comporte un dispositif d'estimation des pertes par effet joule conforme à l'une quelconque des revendications précédentes pour estimer la puissance électrique dissipée par la batterie.

9. Système selon la revendication 8, **caractérisé en ce que** ce système comporte un intégrateur (90) propre à établir l'état de charge actuel de la batterie en fonction d'un état de charge initial de la batterie et des puissances électriques reçue et dissipée par la batterie depuis cet état de charge initial.

10. Système selon la revendication 8 ou 9, **caractérisé en ce que** ce système comporte un estimateur (38) propre à estimer la puissance électrique reçue par la batterie en fonction de l'intensité circulant dans la batterie et de la tension aux bornes de cette batterie.

**11.** Procédé d'estimation des pertes par effet joule d'une batterie comportant les étapes consistant à :

- mesurer (en 152) l'intensité du courant traversant la batterie,
- mesurer (en 152) la tension aux bornes de la batterie,

   **caractérisé en ce que** ce procédé comporte également les étapes consistant à :

- calculer (en 158) la tension ou le courant entre les bornes de chaque résistance d'un modèle électrique prédéfini (48) de la batterie en fonction de l'intensité et de la tension mesurées, ce modèle électrique prédéfini comportant une première résistance (50), un premier circuit RC (Résistance - Condensateur) parallèle et au moins un second circuit RC parallèle raccordés successivement en série, et
- évaluer (en 160) les pertes par effet joule en fonction de la valeur des résistances du modèle électrique prédéfini et des tensions ou courants calculés entre les bornes de ces résistances.

**12.** Procédé d'estimation de l'état de charge d'une batterie en fonction des puissances électriques reçue et dissipée par la batterie,
   **caractérisé en ce qu'**il comporte une étape d'estimation des pertes par effet joule réalisée conformément au procédé de la revendication 11 pour estimer la puissance électrique dissipée par la batterie.

**13.** Support (82) d'enregistrement d'informations, **caractérisé en ce qu'**il comporte des instructions pour l'exécution d'un procédé d'estimation conforme à la revendication 11 ou 12.

FIG.1

*FIG.2*

FIG.3

**_FIG.4_**

114

**_FIG.5_**

14

**FIG.6**

**Office européen**
**des brevets**

## RAPPORT DE RECHERCHE EUROPEENNE

Numéro de la demande

EP 05 29 1189

| | DOCUMENTS CONSIDERES COMME PERTINENTS | | |
|---|---|---|---|
| Catégorie | Citation du document avec indication, en cas de besoin,<br>des parties pertinentes | Revendication<br>concernée | CLASSEMENT DE LA<br>DEMANDE (Int.Cl.7) |
| X | WO 03/001224 A (DOUGHERTY THOMAS J ;<br>JOHNSON CONTROLS TECH CO (US))<br>3 janvier 2003 (2003-01-03)<br>* revendications 1-19 *<br>----- | 1,8,11,<br>13 | G01R31/36 |
| A | US 2003/001581 A1 (LAIG-HORSTEBROCK HELMUT<br>ET AL) 2 janvier 2003 (2003-01-02)<br>* le document en entier *<br>----- | 1,10 | |

**DOMAINES TECHNIQUES**
**RECHERCHES (Int.Cl.7)**

G01R

Le présent rapport a été établi pour toutes les revendications

| Lieu de la recherche | Date d'achèvement de la recherche | Examinateur |
|---|---|---|
| La Haye | 20 juillet 2005 | Six, G |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

........................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 29 1189

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-07-2005

| Document brevet cité au rapport de recherche | Date de publication | Membre(s) de la famille de brevet(s) | Date de publication |
|---|---|---|---|
| WO 03001224    A | 03-01-2003 | EP      1402279 A1<br>WO      03001224 A1<br>US   2004212367 A1 | 31-03-2004<br>03-01-2003<br>28-10-2004 |
| US 2003001581  A1 | 02-01-2003 | DE      10126891 A1 | 05-12-2002 |

EPO FORM P0460

Pour tout renseignement concernant cette annexe : voir Journal Officiel de l'Office européen des brevets, No.12/82